# EUROPÄISCHE PATENTSCHRIFT

(11) **EP 1 625 591 B1**
(45) Veröffentlichungstag und Bekanntmachung des Hinweises auf die Patenterteilung: **06.10.2010**
(21) Anmeldenummer: 04722873.9
(22) Anmeldetag: 24.03.2004
(51) Int. Cl.: G11C 16/04, G11C 7/12, G11C 16/24, H01L 21/8247

(54) **INTEGRIERTE SPEICHER-SCHALTUNGSANORDNUNG, INSBESONDERE UNIFORM-CHANNEL-PROGRAMMING-FLASH-SPEICHER**
INTEGRATED MEMORY CIRCUIT ARRANGEMENT IN PARTICULAR A UNIFORM-CHANNEL-PROGRAMMING FLASH MEMORY
ENSEMBLE CIRCUIT DE MEMOIRE INTEGRE, EN PARTICULIER MEMOIRE FLASH UCP (UNIFORM CHANNEL PROGRAMMING)

(30) Priorität: 22.05.2003 DE 10323244
(43) Veröffentlichungstag der Anmeldung: 15.02.2006
(73) Patentinhaber: Infineon Technologies AG, 85579 Neubiberg (DE)
(72) Erfinder: TEMPEL, Georg, 01277 Dresden (DE)
(74) Vertreter: Kindermann, Peter
(86) Internationale Anmeldenummer: PCT/EP2004/050356
(87) Internationale Veröffentlichungsnummer: WO 2004/105041

(56) Entgegenhaltungen:
- US-A- 5 559 048
- US-A- 5 559 048
- US-B1- 6 243 313
- US-B1- 6 243 313
- US-B1- 6 307 780
- US-B1- 6 438 030
- US-B1- 6 480 422
- US-B2- 6 567 315

## Beschreibung

Die Erfindung betrifft eine Speicher-Schaltungsanordnung mit einer Vielzahl matrixförmig angeordneter Speicherzellen, die jeweils mindestens einen Transistor enthalten, beispielsweise einen Transistor mit einer rundherum bzw. allseitig isolierten Elektrode, d.h. einem so genannten Floating-Gate. Die Speicher-Schaltungsanordnung enthält außerdem Wortleitungen und quer dazu angeordnete Bitleitungen. Die Wortleitungen sind mit Steuerelektroden der Transistoren von Speicherzellen einer Zeile der Matrix elektrisch leitend verbunden. Die Steuerelektrode wird auch als Gate-Elektrode bezeichnet. Die Bitleitungen sind mit Anschlusselektroden der Transistoren von Speicherzellen einer Spalte der Matrix verbunden. Die Anschlusselektroden werden beispielsweise durch in einem Substrat dotierte Bereiche gebildet und bspw. bei Feldeffekttransistoren als Drain bzw. Source bezeichnet.

Die Speicherzellen speichern ihren Speicherinhalt so, dass der Speicherinhalt beim Ausschalten einer Betriebsspannung gelöscht wird oder dass der Speicherinhalt auch beim Ausschalten der Betriebsspannung erhalten bleibt. In diesem Zusammenhang ist von flüchtig speichernden Speicherzellen und von nicht-flüchtig speichernden Speicherzellen die Rede.

Beispielsweise ist eine solche Speicher-Schaltungsanordnung aus der US 6,480,422 B1 bekannt. Die Speicherzellen enthalten dort jeweils einen Floating-Gate-Transistor. Jede Spalte aus Speicherzellen ist mit zwei Bitleitungen verbunden, nämlich mit einer Drainleitung und einer Sourceleitung. Die Sourceleitung wird bspw. für Speicherzellen zweier benachbarter Spalten genutzt. Weitere Speicher-Schaltungsanordnungen sind aus der US 6,567,315 B2, der US 6,307,780 B1, der US 6,438,030 sowie der US 6,243,313 B1 bekannt.

Das Floating Gate bzw. das Speichergate ist eine allseitig isolierte Elektrode. Sofern im Folgenden der Begriff Spalte gebraucht wird, bezeichnet er - sofern nicht anders präzisiert - die Speicherzellen einer Spalte der gesamten Speicheranordnung.

Die Präambel von Anspruch 1 basiert auf Dokument US 6.567.315.

Es ist Aufgabe der Erfindung, eine einfach aufgebaute Speicher-Schaltungsanordnung anzugeben, die insbesondere verbesserte elektronische Eigenschaften hat und die insbesondere nur eine geringe Chipfläche benötigt. Insbesondere soll eine Speicher-Schaltungsanordnung mit geringer Leistungsaufnahme angegeben werden. Die Speicher-Schaltungsanordnung soll insbesondere auch die Beibehaltung bisheriger Potentialverhältnisse oder die Nutzung anderer Potentialverhältnisse für verschiedene Betriebsarten ermöglichten.

Die erfindungsgemäße Schaltungsanordnung enthält die Merkmale des Anspruches 1. In der ersten Betriebsart lässt sich somit das Potential der einen Bitleitung durch eine einfache schaltungstechnische Maßnahme auch an die andere Bitleitung anlegen. Ein Potential, das in anderen Betriebsarten an der zugeschalteten Bitleitung anliegt, wird dann beispielsweise für alle Speicherzellen der Schaltungsanordnung oder für einen Teil der Speicherzellen der Schaltungsanordnung abgeschaltet. Beispielsweise wird das Potential für alle Speicherzellen des Speichers abgeschaltet oder für nur für die Speicherzellen eines Speichersegmentes, in dem die betroffene Spalte liegt. In beiden Fällen lässt sich ein Transistor zum Trennen einsetzen.

Durch das Schaltelement entstehen Freiheitsgrade, die neue Betriebsarten der Speicher-Schaltungsanordnung zulassen. Beispielsweise wird es möglich, an der abgetrennten Spannungszuführung in mehreren oder sogar in allen Betriebsarten das gleiche Potential zu führen. Die zum Potentialwechsel erforderliche Schaltleistung wird geringer.

Bei einer Weiterbildung der Schaltungsanordnung ist eine mit dem Schaltelement elektrisch leitend verbundene Bitleitung in einem dotierten Bereich eines Substrates angeordnet, insbesondere eines Siliziumsubstrates. Die andere mit dem Schaltelement elektrisch leitend verbundene Bitleitung ist dagegen eine Bitleitung, die eine Metallschicht enthält oder aus Metall besteht. Der dotierte Bereich ist beispielsweise zwischen zwei Isoliergräben zum Isolieren der Speicherzellen einander benachbarter Spalten angeordnet. Alternativ lässt sich der dotierte Bereich auch in einem solchen Isoliergraben anordnen. Die Metallleitung hat im Vergleich zu einem dotierten Bereich einen kleineren Widerstand, so dass das Heranführen der Betriebsspannung bis zum Schaltelement mit einem vergleichsweise kleinem Spannungsabfall und Leistungsverlust verbunden ist. Erst am Schaltelement wird der dotierte Bereich hinzugeschaltet. Ist die Länge des dotierten Bereiches an dessen Leitfähigkeit angepasst, so sind Spannungsabfälle bzw. Verluste hinsichtlich der Schreib-, Lese- oder Löschzeiten im Vergleich zur ausschließlichen Verbindung von Bitleitungen aus Metall hinnehmbar. Besteht eine Bitleitung aus Metall, so treten zumindest hinsichtlich dieser Bitleitungen die mit der Verwendung von dotierten Bereichen verbundenen Nachteile bezüglich der spezifischen Leitfähigkeit und eines damit verbundenen Spannungsabfall nicht auf. Außerdem lässt sich durch Verwendung mehrerer Schaltelemente je Spalte bzw. durch geschickte Anordnung des Schaltelementes bzw. der Schaltelemente, beispielsweise auf halber Länge beider Bitleitungen, erreichen, dass die mit dem dotierten Bereich verbundenen Nachteile den Betrieb der Schaltungsanordnung nicht so schwerwiegend beeinträchtigen.

Bei einer nächsten Weiterbildung sind die Bitleitungen lokale Bitleitungen, die über weitere Schaltelemente mit globalen Bitleitungen elektrisch leitfähig verbindbar sind. Die lokalen Bitleitungen legen ein Speichersegment dadurch fest, dass sie nur mit einem Teil der Zellen einer Spalte der Speicher-Schaltungsanordnung verbunden sind. Die Schaltungsanordnung enthält mindestens zwei Speichersegmente. Das Verwenden von Speichersegmenten bietet die Möglichkeit, die Speicher-Schaltungsanordnung ähnlich wie eine Magnetspeicherplatte anzusteuern, die ebenfalls Segmente enthält. Außerdem wird durch die Verwendung von lokalen und globalen Bitleitungen erreicht, dass die globalen Bitleitungen in oberen Metallisierungslagen angeordnet werden können und beispielsweise einen größeren Querschnitt haben als die lokalen Bitleitungen oder der Abstand zueinander vergrößert ist. Ersteres reduziert den Bitleitungswiderstand (R) und letzteres die kapazitive Last (C) der Bitleitungen. Damit ist die RC Verzögerung durch die globalen Bitleitungen geringer und die Zugriffszeiten der Schaltungsanordnung verbessern sich. Das Verwenden von Speichersegmenten bietet außerdem eine einfache Möglichkeit, die Länge der lokalen Bitleitungen zu begrenzen, insbesondere der in dotierten Bereichen geführten lokalen Bitleitungen.

Bei einer nächsten Weiterbildung ist die Anzahl der globalen Bitleitungen in der Schaltungsanordnung halb so groß wie die Anzahl der metallischen lokalen Bitleitungen. Wenn Sourceleitungen in verschiedenen Spalten eines Speichersegmentes in einer Betriebsart voneinander verschiedene Potentiale führen müssen und wenn Drainleitungen in einer Betriebsart voneinander verschiedene Potentials führen müssen, sind selbst bei Doppelnutzung von globalen Leitungen für zwei lokale Leitungen ohne Verwendung der Schaltelemente mehr globale Bitleitungen erforderlich als gemäß der Weiterbildung.

Bei einer anderen Weiterbildung ist das Schaltelement an einem Ende einer Reihe von Speicherzellen einer Spalte eines Speichersegmentes angeordnet. Alternativ ist das Schaltelement zwischen den Speicherzellen einer Spalte eines Speichersegmentes angeordnet, vorzugsweise in der Mitte der Spalte, um in zwei gleich lange Abschnitte der in einem dotierten Bereich angeordneten Bitleitungen einen Strom einzuspeisen. Der Spannungsabfall über der Bitleitung im dotierten Bereich lässt sich so auf einfache Art weiter verringern.

Die Anmeldung offenbart auch eine Speicher-Schaltungsanordnung mit den eingangs genannten Elementen, die mindestens ein weiteres Schaltelement je Spalte enthält, das das Herstellen und das Trennen einer elektrisch leitfähigen Verbindung einer in Zeilenrichtung verlaufenden Sammelleitung mit jeweils einer Bitleitung ermöglicht. Die Weiterbildung geht von der Überlegung aus, dass ein lokales Herstellen und Trennen der Verbindung zu der Sammelleitung im Vergleich zu einem segmentbezogenen oder globalen Herstellen und Trennen einer Verbindung zu der Sammelleitung mit einem geringen Leistungsbedarf verbunden ist. Außerdem werden Betriebsarten mit Potentialverhältnissen ermöglicht, die ohne die Erfindung gemäß zweitem Aspekt zusätzliche Leitungen in Spaltenrichtung erfordern würden.

Insbesondere eine Kombination der beiden Schaltungsanordnungen führt zu einer einfach aufgebauten Schaltungsanordnung mit besonders guten elektrischen Eigenschaften, beispielsweise hinsichtlich der Leistungsaufnahme. Außerdem werden wiederum Betriebsarten mit Potentialverhältnissen ermöglicht, die ohne die Kombination zusätzliche Leitungen in Spaltenrichtung erfordern würden. Weiterhin ist die benötigte Chipfläche auf Grund der Kombination klein.

Bei einer Weiterbildung enthält die Schaltungsanordnung eine Steuereinheit, die die Schaltelemente zum Verbinden zweier Bitleitungen wechselweise zu den Schaltelementen zum Verbinden der Sammelleitung mit der Bitleitung ansteuert. Durch das wechselweise Ansteuern wird gewährleistet, dass keine Potentialkonflikte auf einer Bitleitung auftreten.

Bei einer anderen Weiterbildung ist für eine Spalte das Schaltelement zum Verbinden der beiden Bitleitungen benachbart zu dem Schaltelement zum Verbinden einer Bitleitung mit der Sammelleitung angeordnet. Alternativ werden die beiden Schaltelemente an verschiedenen Stellen, insbesondere an verschiedenen Enden der Spalte angeordnet.

Bei einer nächsten Weiterbildung enthält die Schaltungsanordnung eine Ansteuerschaltung, die so aufgebaut ist, dass ein Speicherzellentransistor mit einem gleichmäßigen Kanal programmiert und/oder gelöscht wird (UCP Uniform Channel Programming), so dass das Tunneloxid gleichmäßig beansprucht wird. Insbesondere bei dieser Art der Programmierung werden die durch die Schaltelemente erzielten Vorteile besonders groß.

Bei einer anderen Weiterbildung sind die Bitleitungen einer Spalte von Speicherzellen in Normalenrichtung einer Substrathauptfläche überlappend zueinander angeordnet. Eine Substrathauptfläche ist dabei eine Fläche mit einem Flächeninhalt zu anderen Flächen, z.B. zu Randflächen, der größer als der Flächeninhalt dieser Flächen ist. Mit anderen Worten ausgedrückt, sind die Bitleitungen so angeordnet, dass beide Bitleitungen übereinander liegen, wenn die Substrathauptfläche in der Horizontalen liegt.

Im Folgenden werden Ausführungsbeispiele der Erfindung an Hand der beiliegenden Zeichnungen erläutert. Darin zeigen:
- Figur 1: Spannungsverhältnisse an Speicherzellen beim Pro- grammieren, Löschen und Lesen,
- Figur 2: einen Schaltplan eines Speicherzellenfeldes,
- Figur 3: einen Schaltplan einer Spalte des Speicherzellen- feldes, und
- Figur 4: das Layout einer Speicherschaltung.

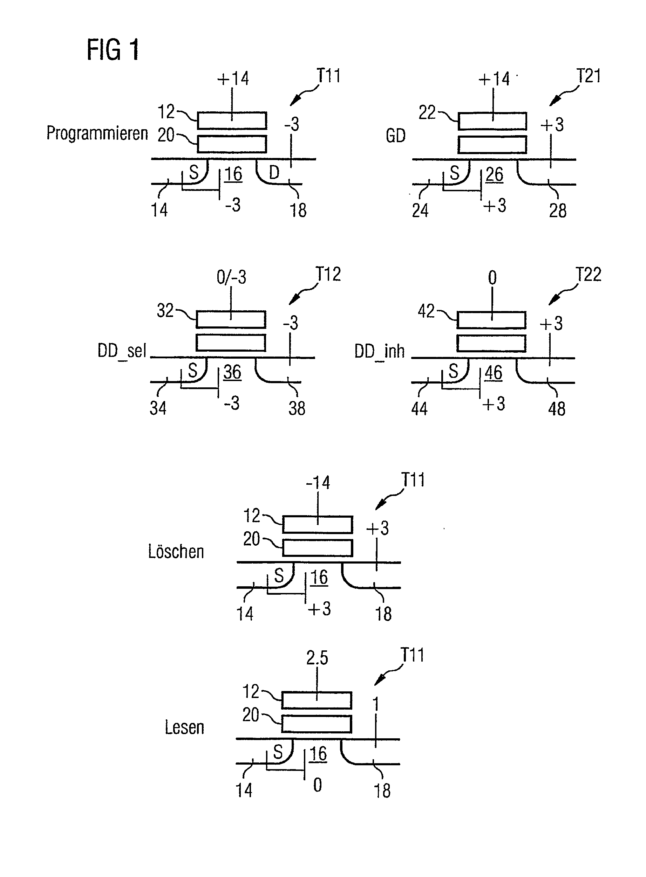

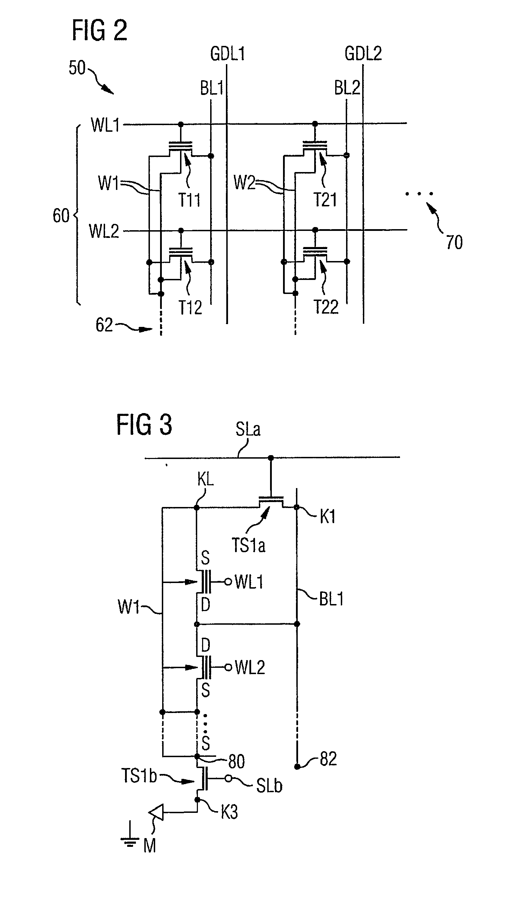

Figur 1 zeigt ein Ausführungsbeispiel für Spannungsverhältnisse an Speicherzellen beim Programmieren, beim Löschen und beim Lesen von Speicherzellen einer Schaltungsanordnung, die unten an Hand der Figuren 2 bis 4 näher erläutert wird. Die im Zusammenhang mit der Figur 1 genannten Spannungswerte sind nur Beispiele und können in weiten Grenzen abweichend von den genannten Spannungswerten gewählt werden, z.B. abweichend um plus oder minus 50 Prozent bzw. 30 Prozent des jeweiligen Spannungswertes. Auch sind Betriebsarten mit grundsätzlich anderen Spannungswerten realisierbar. Beim Erläutern der Figur 1 wird auf Speichertransistoren T11 bis T22 Bezug genommen, deren Anordnung in einem Speicherzellenfeld unten an Hand der Figur 2 näher erläutert wird. Der Speichertransistor T11 wird exemplarisch zum Erläutern der Betriebsarten gewählt. Selbstverständlich können andere Transistoren auf die gleiche Art beschrieben, gelöscht oder gelesen werden.

Beim Programmieren wird, wie in Figur 1 dargestellt, an einer Gate-Elektrode 12 des Speichertransistors T11 eine Spannung von +14 Volt angelegt. An einem Sourcebereich 14, einem Drainbereich 18 und an einem Substratbereich 16 des Speichertransistors T11 liegt beim Programmieren eine Spannung von jeweils -3 Volt an. Aufgrund dieser Spannungsverhältnisse fließt ein Tunnelstrom von einem Inversionskanal im Substrat 16 ganzflächig durch ein Tunneloxid in die rundherum isolierte Elektrode 20 des Transistors T11.

Beim Programmieren liegen an Transistoren in derselben Zeile wie der Speichertransistor T11, jedoch in einer anderen Spalte, z.B. am Transistor T21, die folgenden Spannungen an: - +14 Volt an einer Gate-Elektrode 22,
- +3 Volt an einem Sourcebereich 24 und an einem Substratbereich 26, sowie
- +3 Volt an einem Drainbereich 28 des Transistors T21.

An Transistoren in der gleichen Spalte wie der Transistor T11, jedoch in einer anderen Zeile des Speicherzellenfeldes, z.B. am Transistor T12, liegen die folgenden Potentiale an:
- 0 Volt oder -3 Volt an einer Gate-Elektrode 32,
- -3 Volt an einem Sourcebereich 34 und an einem Substratbereich 36, sowie
- -3 Volt an einem Sourcebereich 38 des Transistors T12.

An Transistoren in anderen Zeilen und in anderen Spalten als der Transistor T11, z.B. am Transistor T22, liegen die folgenden Spannungen an:
- 0 Volt an einer Gate-Elektrode 42,
- +3 Volt an einem Sourcebereich 44 und an einem Substratbereich 46, sowie
- +3 Volt an einem Drainbereich 48.

Beim Löschen werden alle Speichertransistoren eines Speichersegmentes gleichzeitig gelöscht, so dass an allen Speichertransistoren T11 bis T22 die gleichen Potentialverhältnisse bestehen. In Figur 1 ist der Löschvorgang für den Speichertransistor T11 stellvertretend für alle Speichertransistoren T11 bis T22 dargestellt. Beim Löschen liegen die folgenden Spannungen am Transistor T11 an:
- -14 Volt an der Gate-Elektrode 12,
- +3 Volt am Sourcebereich 14 und am Substratbereich 16, sowie
- +3 Volt am Drainbereich 18.

Beim Lesen des Speicherzustandes des Speichertransistors T11 liegen die folgenden Potentiale an:
- +2,5 Volt an der Gate-Elektrode 12,
- 0 Volt am Sourcebereich 14 und am Substratbereich 16, sowie
- 1 Volt am Drainbereich 18.

Figur 2 zeigt einen Schaltplan einer Speicherschaltung 50, die unter anderem ein Zellenfeld enthält, das in mehrere Speichersegmente 60, 62 unterteilt ist. Die Speichersegmente 60, 62 sind gleich aufgebaut, so dass im Folgenden nur der Aufbau des Speichersegmentes 60 erläutert wird. Das Speichersegment 60 enthält eine Vielzahl von Speichertransistoren T11 bis Tmn, wobei m die Anzahl von Spalten und n die Anzahl der Zeilen in einem Speichersegment bezeichnet. Jede Speicherzelle des Speicherzellenfeldes besteht aus einem Speichertransistor, z.B. aus dem Transistor T11. Die Speicherzellen des Speichersegmentes sind matrixförmig angeordnet. Die Gate-Elektroden der Speichertransistoren T11, T21 einer Zeile sind an eine Wortleitung WL1 angeschlossen. Die Gate-Elektroden der Speichertransistoren T12, T22 bis T2m sind an einer Wortleitung WL2 angeschlossen. Ebenso sind beispielsweise weitere vierzehn Wortleitungen des Speichersegmentes 60 jeweils mit den Gate-Elektroden der Speichertransistoren einer Zeile verbunden.

Die Speichertransistoren T11 bis Tmn eines Speichersegmentes 60 sind alle gleich aufgebaut. Deshalb wird auf die Erläuterungen zu Figur 1 für den Speichertransistor T11 verwiesen.

Draingebiete von Speichertransistoren einer Spalte des Speichersegmentes 60 sind mit einer lokalen Bitleitung verbunden, z.B. die Drainbereiche der Speichertransistoren T11 und T12 mit einer lokalen Bitleitung BL1. Eine lokale Bitleitung BL2 ist mit den Drainbereichen der Transistoren der zweiten Spalte verbunden, insbesondere mit den Drainbereichen der Speichertransistoren T21 und T22. Weitere Speicherzellen 70 des Speichersegmentes 60 sind durch Punkte angedeutet. Beispielsweise enthält das Speichersegment 60 1024 Spalten.

Die Sourcebereiche sowie die Substratbereiche der Speichertransistoren einer Spalte sind jeweils über eine dotierte Wanne W1, W2 bis Wm verbunden. Zwischen den Wannen W1, W2 usw. liegen jeweils Isoliergräben. Eine Wanne W1, W2 wird beispielsweise durch eine p-dotierte Schicht und eine darunter liegende n-dotierte Schicht gebildet. Die Kontaktierung der Sourcebereiche der Speichertransistoren T11 bis T22 mit einer Wanne W1, W2 wird beispielsweise über eine Silizidierung und einen in die Wanne eindotierten Kontaktbereich hergestellt, siehe bspw. US-Patentschrift 6,438,030 B1.

Über alle Speichersegmente 60, 62 verlaufen außerdem in Spaltenrichtung globale Drainleitungen, von denen in Figur 2 zwei globale Drainleitungen GDL1 und GDL2 dargestellt sind. Bei einem alternativen Ausführungsbeispiel wird eine globale Drainleitung mit Hilfe von Auswahltransistoren für zwei lokale Bitleitungen eines Speichersegmentes 60, 62 genutzt. In Figur 2 sind Auswahltransistoren zum Anschließen der lokalen Bitleitungen BL1 und BL2 an die globalen Drainleitungen GDL1 und GDL2 nicht dargestellt.

Figur 3 zeigt einen Schaltplan der ersten Spalte des Speichersegmentes 60. Die anderen Spalten des Speichersegmentes 60 sind wie die erste Spalte aufgebaut und werden deshalb nicht weiter erläutert. Zusätzlich zu den bereits an Hand der Figur 2 erläuterten Elementen enthält die erste Spalte des Speichersegmentes 60 zwei Konfigurationstransistoren TS1a und TS1b. Die Arbeitsstrecke des Konfigurationstransistors TS1a liegt zwischen der Wanne W1 und der lokalen Bitleitung BL1, d.h. Source an der Wanne W1 und Drain an der lokalen Bitleitung BL1. Die Steuerelektrode des Konfigurationstransistors TS1a liegt an einer Steuerleitung SLa, die auch mit den Steuerelektroden der Konfigurationstransistoren TS2a, TS3a usw. der anderen Spalten des Speichersegmentes 60 verbunden ist.

Der Konfigurationstransistor TS1b liegt am unteren Ende der ersten Spalte. Seine Arbeitsstrecke liegt zwischen der Wanne W1 und einer Masseleitung M, die ein Potential von 0 Volt führt. Die Steuerelektrode des Konfigurationstransistors TS1b ist mit einer Steuerleitung SLb verbunden, an der auch die Steuerelektroden der anderen unteren Konfigurationstransistoren TS2b, TS3b usw. des Speichersegmentes 60 angeschlossen sind.

Bei einem anderen Ausführungsbeispiel liegt der Konfigurationstransistor TS1a zwischen zwei Schaltungspunkten 80, 82 am unteren Ende der Wanne W1 bzw. am unteren Ende der lokalen Bitleitung BL1. Bei einem weiteren Ausführungsbeispiel liegt der Konfigurationstransistor TS1a zwischen der achten und der neunten Speicherzelle der ersten Spalte des Speichersegmentes 60.

Zusätzlich zu den Konfigurationstransistoren TS1a und TS1b gibt es für die erste Spalte des Speichersegmentes 60 auch einen nicht dargestellten Auswahltransistor zum Verbinden der lokalen Bitleitung BL1 mit der globalen Drainleitung GDL1. Dieser Auswahltransistor ist in Figur 3 jedoch nicht dargestellt.

Während des Betriebes der Schaltungsanordnung 50 werden die Konfigurationstransistoren TS1a und TS1b wechselweise so angesteuert, dass jeweils ein Konfigurationstransistor sperrt und der andere Konfigurationstransistor leitet. Leitet der Konfigurationstransistor TS1a, so ist die Bitleitung BL1 mit der Wanne W1 verbunden. Die Wanne W1 und damit auch die Sourceleitung der ersten Spalte führt das Potential der Bitleitung BL1. Leitet der Transistor TS1a, so trennt der Transistor TS1b die Wanne W1 und die Sourceleitung von der Masseleitung M. Leitet dagegen der Konfigurationstransistor TS1b, so wird das Massepotential an die Wanne W1 und die Sourceleitung gelegt. Wenn der Konfigurationstransistor TS1b leitet, ist der Konfigurationstransistor TS1a gesperrt, so dass kein Potentialkonflikt zwischen dem Potential der Wanne W1 und dem Potential auf der Bitleitung BL1 auftritt.

Der Konfigurationstransistor TS1a ist beim Schreiben einer Speicherzelle der ersten Spalte des Speichersegmentes 60 oder einer anderen Speicherzelle des Speichersegmentes 60 leitend. Der Transistor TS1a ist außerdem leitend, wenn eine Speicherzelle im Speichersegment 60 gelesen wird, die nicht in der ersten Spalte angeordnet ist.

Der Konfigurationstransistor TS1b ist leitend, wenn eine Speicherzelle der ersten Spalte des Speichersegmentes 60 gelesen wird. Beim Löschen ist der Konfigurationstransistor TS1a leitend.

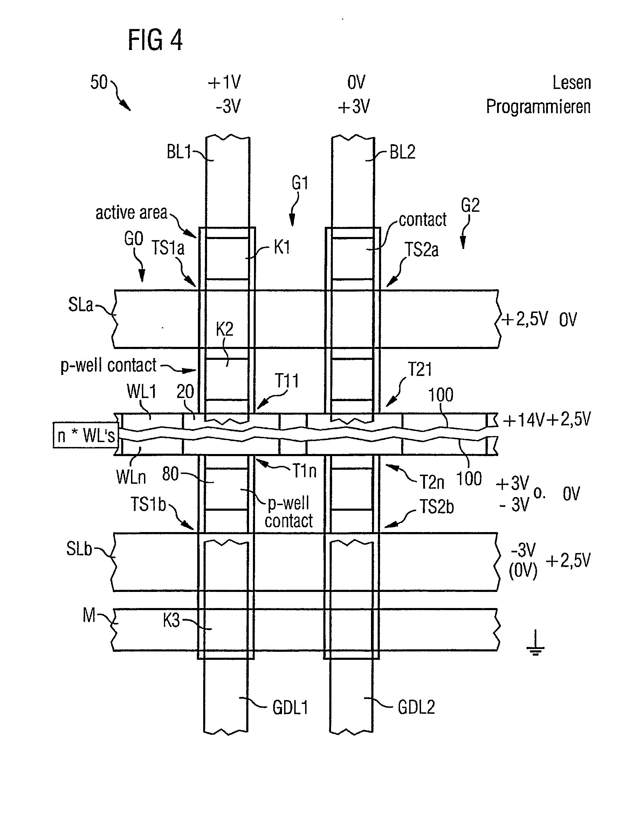

Figur 4 zeigt das Layout eines Teils der Schaltungsanordnung 50. Die Bedeutung der Bezugszeichen wurde bereits oben an Hand der Figuren 1 bis 3 erläutert. In ein Substrat wurden Gräben G0 bis Gm eingebracht und mit einem Isoliermaterial gefüllt, beispielsweise mit Siliziumdioxid. Zwischen den Gräben G0, G1, G2 usw. bzw. vor dem Herstellen der Gräben G0, G1, G2 usw. wurden die Isolierwannen W1, W2 usw. erzeugt. Beispielsweise wurde in einem leicht p-dotierten Substrat eine n-dotierte Schicht eingebracht und darüber eine p-dotierte Schicht. In Figur 4 sind die Wannen W1, W2 usw. nicht dargestellt, da sie von den aktiven Gebieten der Transistoren überdeckt werden, die sich an der Substratoberfläche befinden.

Die Speichertransistoren T11 bis T22 bzw. Tmn des Speicherzellenfeldes haben ein Layout, wie es bisher auch verwendet wird. Deshalb ist dieses Layout in Figur 4 nicht vollständig dargestellt, sondern nur durch zwei Bruchlinien 100 angedeutet.

In der ersten Metallisierungslage verlaufen in vertikaler Richtung über das Zellenfeld die lokalen Bitleitungen BL1, BL2 usw. Diese Bitleitungen enden an dem Drainkontakt des Transistors T1n, T2n usw., d.h. am Drainkontakt des letzten Transistors einer Spalte. In der ersten Metallisierungsebene befindet sich außerdem die Masseleitung M, die in Figur 4 in horizontaler Richtung verläuft, d.h. im rechten Winkel zu den lokalen Bitleitungen BL1, BL2 usw.

Die lokalen Bitleitungen BL1, BL2 usw. sind über Kontakte K1 mit den Drainbereichen der Konfigurationstransistoren TS1a, TS1b usw. verbunden. Außerdem sind die Bitleitungen BL1, BL2 mit den Draingebieten der Speichertransistoren des Speicherzellenfeldes verbunden. Die Masseleitung M ist über Kontakte K3 mit dem Sourcegebiet des Konfigurationstransistors TS1b, TS2b usw. verbunden.

In der zweiten Metallisierungsebene verlaufen in vertikaler Richtung die globalen Drain- bzw. Bitleitungen GDL1, GDL2 usw. Wie bereits erwähnt, werden die globalen Drainleitungen GDL1, GDL2 mit der jeweiligen lokalen Bitleitung BL1, BL2 usw. über nicht dargestellte Auswahltransistoren verbunden.

Ausgehend von den aktiven Sourcegebieten der Speichertransistoren T11 bis Tmn gibt es jeweils Kontaktierungen zu den Wannen W0, W1 usw., siehe beispielsweise die Kontaktierung K2 des Speichertransistors T11 und den Kontakt-Anschluss 80 des Speichertransistors T1n in der ersten Spalte. Die Kontaktierungen K2 und 80 sind auch in der Figur 3 eingezeichnet.

Im Folgenden werden die Potentiale beim Programmieren des Speichertransistors T11 angegeben:
- -3 Volt an der Bitleitung BL1,
- +3 Volt an der Bitleitung BL2,
- +2,5 Volt an der Steuerleitung SLa,
- +14 Volt an der ausgewählten Wortleitung (hier WL1),
- 0 oder -3 Volt an den nicht ausgewählten Wortleitungen (nicht dargestellt),
- -3 Volt an der Steuerleitung SLb, und somit
- -3 Volt an der Wanne W0 und +3 Volt an der Wanne W1.

Somit wird durch Verwendung der Konfigurationstransistoren erreicht, dass benachbarte Wannen W0 und W1 auf verschiedenem Potential liegen. Zusätzliche vertikale Leitungen zum Anlegen der Potentiale zusätzlich zu den lokalen Bitleitungen BL1, BL2 sind nicht erforderlich, so dass nur eine kleine Chipfläche für die Schaltungsanordnung 50 benötigt wird.

Beim Lesen von T11 werden die folgenden Potentiale angelegt:
- +1 Volt an der lokalen Bitleitung BL1,
- 0 Volt an der lokalen Bitleitung BL2,
- 0 Volt an der Steuerleitung SLa,
- +2,5 Volt an der Wortleitung WL1,
- 0 Volt an den nicht ausgewählten Wortleitungen (nicht dargestellt),
- +2,5 Volt an der Steuerleitung SLb, und damit
- an den Wannen W0, W1 jeweils 0 Volt.

Aufgrund der Verwendung der Konfigurationstransistoren ist es in der Lese-Betriebsart möglich, die Wanne W1 und die Bitleitung BL1 auf verschiedene Potentiale zu schalten, und die Wanne W2 und die Bitleitung BL2 auf gleiche Potentiale. Dies ist möglich, obwohl die Konfigurationstransistoren TS1a, TS2a usw. über eine gemeinsame Steuerleitung SLa und die Konfigurationstransistoren TS1b, TS2b usw. über eine gemeinsame Steuerleitung SLb angesteuert werden.

Bei einem anderen Ausführungsbeispiel wird eine lokale Bitleitung BL1 über mindestens zwei Konfigurationstransistoren TS1a wahlweise mit der darunterliegenden Wanne kontaktiert. Zusätzlich oder alternativ gibt es je Sektor auch mehrere Masseleitungen M, so dass jede Wanne mit Hilfe von mindestens zwei Konfigurationstransistoren TS1b kontaktiert werden kann. Durch diese Maßnahme ist ein schneller Lesezugriff möglich und es entstehen nur vergleichsweise kleine Spannungsabfälle entlang der Wannen und damit der Sourceleitungen.

Aufgrund der erläuterten Schaltungsanordnung ist es möglich, den kleinstmöglichen Versatz zwischen benachbarten Bitleitungen BL1, BL2 zu erzielen. Es ist nur eine einzige metallische Bitleitung je Spalte erforderlich. Beim Stand der Technik werden je Spalte jeweils zwei metallische Bitleitungen benötigt, nämlich ein metallische Sourceleitung und eine metallische Bitleitung.

Bei einem alternativen Ausführungsbeispiel werden benachbarte Bitleitungen nicht bis auf den minimal möglichen Versatz angenähert, weil die metallischen Bitleitungen breiter ausgeführt werden oder weil die Kapazitäten zwischen benachbarten Bitleitungen aufgrund einer Vergrößerung des Abstandes zwischen diesen Bitleitungen verringert werden sollen. Damit ergeben sich an Stelle einer Flächeneinsparung verbesserte elektronische Eigenschaften der Speicherschaltung. Auch ein Kompromiss zwischen einer Verringerung der Chipfläche und einer Verbesserung der elektrischen Eigenschaften wird bei einem anderen Ausführungsbeispiel erzielt. Durch die Verringerung der Anzahl der Metallleitungen wird außerdem die Fehleranfälligkeit bei der Herstellung reduziert und damit wird eine höhere Ausbeute bei der Herstellung der Schaltungsanordnung 50 erreicht.

Die Erfindung ist jedoch nicht auf die erläuterte Speicher-Schaltungsanordnung beschränkt. So lässt sich beispielsweise das bekannte ETOX-Konzept durch die Verwendung von Konfigurationstransistoren so abwandeln, dass weiterhin mit dem CHE-Prinzip (Channel Hot Electrons) programmiert wird und mit Tunnelstrom gelöscht wird. Jedoch wird zum Löschen ein Tunnelstrom benutzt, der gleichmäßig über das Tunneloxid zwischen Floating Gate und Substrat verteilt ist und so dass Tunneloxid weniger schädigt, als es bei dem bisher verwendeten Tunnelstrom in nur einem Teilbereich des Tunneloxides der Fall ist. Weitere Anwendungen des erfindungsgemäßen Konzeptes betreffen insbesondere die Verringerung der Leistungsaufnahme der Speicherschaltung.

Insbesondere lässt sich die Erfindung auch dann einsetzen, wenn nur Bitleitungen in dotierten Bereichen verwendet werden oder wenn Bitleitungen in Isoliergräben geführt werden.

## Patentansprüche

1. Integrierte Speicher-Schaltungsanordnung (50),
mit einer Vielzahl matrixförmig angeordneter Speicherzellen, die jeweils mindestens einen Transistor (T11, T21) enthalten, mit Wortleitungen (WL1, WL2) an den Steuerelektroden (20) der Transistoren (T11, T21) von Speicherzellen einer Zeile der Matrix,
mit Bitleitungen (BL1, BL2, B1, B2) an Anschlusselektroden (24, 28) der Transistoren (T11, T21) von Speicherzellen einer Spalt, der Matrix,
mit mindestens einem Schaltelement (TS1a, TS2a) je Spalte, welches das Herstellen und Trennen einer elektrisch leitenden Verbindung zweier Bitleitungen (BL1, W1) derselben Spalte ermöglicht,
und mit einer Sammelleitung (M) in Zeilenrichtung der Matrix, wobei mindestens ein weiteres Schaltelement (TS1b) je Spalte das Herstellen und Trennen einer elektrisch leitfähigen Verbindung der Sammelleitung (M) mit jeweils einer Bitleitung (W1, W2) ermöglicht,
wobei die Bitleitungen (BL1, BL2) lokale Bitleitungen sind, und wobei eine Ansteuerschaltung so aufgebaut ist, dass der Transistor (T11) mit einem gleichmäßigen Kanal programmiert wird, so dass das Tunneloxid gleichmäßig beansprucht wird,
**dadurch gekennzeichnet, dass** Isoliergräben (G1, G2) vorhanden sind, zwischen denen voneinander isolierte dotierte Wannen liegen, die jeweils die Substratbereiche der Transistoren einer Spalte verbinden, und
**dadurch** dass eine Steuereinheit vorhanden ist, die die Schaltelemente (TS1a) zum Verbinden zweier Bitleitungen (BL1, W1) *während des Programmierens* wechselweise zu den Schaltelementen (TS1b) zum Verbinden der Sammelleitung (M) mit der Bitleitung (W1, W2) ansteuert, wobei immer nur eine der Schaltelemente (TS1a, TS1b) leitet und das andere Schaltelement sperrt.

2. Schaltungsanordnung (50) nach Anspruch 1, **dadurch gekennzeichnet , dass** eine mit einem Schaltelement (TS1a) elektrisch leitend verbundene Bitleitung (W1) in einem dotierten Bereich angeordnet ist, vorzugsweise in einem dotierten Bereich eines Halbleitersubstrats,
und dass die andere mit dem Schaltelement (TS1) elektrisch leitend verbundene Bitleitung (BL1) eine metallische Leitung ist, die aus einem Metall besteht oder eine Metallschicht enthält.

3. Schaltungsanordnung (50) nach Anspruch 1 oder 2, **dadurch gekennzeichnet, dass** die Bitleitungen (BL1, BL2) lokale Bitleitungen sind, die über weitere Schaltelemente mit globalen Bitleitungen (GBL1, GBL2) elektrisch leitfähig verbindbar sind, wobei die lokalen Bitleitungen (BL1, BL2) ein Speichersegment (60) festlegen, und wobei die Schaltungsanordnung (50) mindestens zwei Speichersegmente (60, 62) enthält.

4. Schaltungsanordnung (50) nach Anspruch 3, **dadurch gekennzeichnet , dass** die Anzahl globaler Bitleitungen (GBL1, GBL2) halb so groß ist wie die Anzahl metallischer lokaler Bitleitungen (BL1, BL2).

5. Schaltungsanordnung (50) nach Anspruch 3 oder 4, **dadurch gekennzeichnet, dass** das Schaltelement (TS1a) an einem Ende der Speicherzellen (T11, T12) einer Spalte eines Speichersegmentes (60) angeordnet ist,
oder dass das Schaltelement (TS1a) zwischen den Speicherzellen einer Spalte eines Speichersegmentes (60) angeordnet ist, vorzugsweise in der Mitte einer Spalte.

6. Schaltungsanordnung (50) nach Anspruch 5, zweite Alternative, **dadurch gekennzeichnet , dass** das Schaltelement (TS1a) zwischen den Speicherzellen einer Spalte eines Speichersegmentes (60) in der Mitte einer Spalte angeordnet ist.

7. Schaltungsanordnung (50) nach einem der vorhergehenden Ansprüche, **dadurch gekennzeichnet ,**
**dass** die Sammelleitung (M) beim Lesen und Programmieren das gleiche Potential führt.

8. Schaltungsanordnung nach Anspruch 7, **dadurch gekennzeichnet, dass** die beiden Schaltelemente (TS1a, TS1b) für eine Spalte von Speicherzellen eines Speichersegmentes (60) zueinander benachbart oder nicht zueinander benachbart angeordnet sind, insbesondere an verschiedenen Enden der Spalte.

9. Schaltungsanordnung (50) nach einem der vorhergehenden Ansprüche, **dadurch gekennzeichnet , dass** jede Speicherzelle nur einen Transistor (T11) enthält,
und/oder dass der Transistor (T11) ein Floating-Gate-Transistor ist,
und/oder dass die Ansteuerschaltung so aufgebaut ist, dass der Transistor (T11) mit einem gleichmäßigen Kanal programmiert und/oder gelöscht wird, insbesondere unter Verwendung eines Tunnelstroms,
und/oder dass die Schaltelemente (TS1a, Ts1b) Feldeffekttransistoren oder Analogschalter sind, die vorzugsweise einen zu einem nMOS-Transistor parallel geschalteten pMOS-Transistor enthalten,
und/oder dass die Steuerelemente (TS1a, TS2a) zum Verbinden der Bitleitungen (BL1, W1) mit einer gemeinsamen Steuerleitung (SLa) elektrische leitfähig verbunden sind, insbesondere die Steuerelemente (TS1a, TS2a) eines Speichersegmentes (60), und/oder dass die Steuerelemente (TS1b, TS2b) zum Verbinden der Sammelleitung (M) mit den Bitleitungen (W1, W2) mit einer
gemeinsamen Steuerleitung (SLb) elektrische leitfähig verbunden sind, insbesondere die Steuerelemente (TS1b, TS2b) eines Speichersegmentes (60),
und/oder dass die Schaltungsanordnung zusätzlich zu den Schaltelementen Multiplexschaltungen zum Auswählen von Wortleitungen und Bitleitungen enthält,
und/oder dass die Schaltelemente keine Datenspeicherfunktion haben.

10. Schaltungsanordnung (50) nach einem der vorhergehenden Ansprüche, **dadurch gekennzeichnet, dass** lokale Bitleitungen (BL1, W1) einer Spalte in Normalenrichtung einer Substrathauptfläche überlappend zueinander angeordnet sind.

## Claims

1. Integrated memory circuit arrangement (50),
having a multiplicity of memory cells arranged in matrix-type fashion, said memory cells each containing at least one transistor (T11, T21), having word lines (WL1, WL2) at the control electrodes (20) of the transistors (T11, T21) of memory cells of a row of the matrix,
having bit lines (BL1, BL2, B1, B2) at terminal electrodes (24, 28) of the transistors (T11, T21) of memory cells of a column of the matrix,
having at least one switching element (TS1a, TS2a) per column which enables the production and disconnection of an electrically conductive connection of two bit lines (BL1, W1) of the same column,
and having a collective line (M) in the row direction of the matrix, at least one further switching element (TS1b per column enabling the production and disconnection of an electrically conductive connection of the collective line (M) to a respective bit line (W1, W2),
the bit lines (BL1, BL2) being local bit lines, and a drive circuit being constructed in such a way that the transistor (T11) is programmed with a uniform channel, so that the tunnel oxide is stressed uniformly, **characterized in that** isolation trenches (G1, G2) are present, between which lie doped wells which are insulated from one another and which in each case connect the substrate regions of the transistors of a column, and **in that** a control unit is present, which during the programming drives the switching elements (TS1a) for connecting two bit lines (BL1, W1) alternately to the switching elements (TS1b) for connecting the collective line (M) to the bit line (W1, W2), only ever one of the switching elements (TS1a, TS1b) turning on and the other switching element turning off.

2. Circuit arrangement (50) according to Claim 1, **characterized in that** one bit line (W1) which is electrically conductively connected to a switching element (TS1a) is arranged in a doped region, preferably in a doped region of a semiconductor substrate,
and **in that** the other bit line (BL1) which is electrically conductively connected to the switching element (TS1) is a metallic line comprising a metal or containing a metal layer.

3. Circuit arrangement (50) according to Claim 1 or 2, **characterized in that** the bit lines (BL1, BL2) are local bit lines which can be electrically conductively connected to global bit lines (GBL1, GBL2) via further switching elements, the local bit lines (BL1, BL2) defining a memory segment (60), and the circuit arrangement (50) containing at least two memory segments (60, 62).

4. Circuit arrangement (50) according to Claim 3, **characterized in that** the number of global bit lines (GBL1, GBL2) is half as large as the number of metallic local bit lines (BL1, BL2).

5. Circuit arrangement (50) according to Claim 3 or 4, **characterized in that** the switching element (TS1a) is arranged at an end of the memory cells (T11, T12) of a column of a memory segment (60),
or **in that** the switching element (TS1a) is arranged between the memory cells of a column of a memory segment (60), preferably in the centre of a column.

6. Circuit arrangement (50) according to Claim 5, second alternative, **characterized in that** the switching element (TS1a) is arranged between the memory cells of a column of a memory segment (60), in the centre of a column.

7. Circuit arrangement (50) according to one of the preceding claims, **characterized in that** the collective line (M) carries the same potential during reading and programming.

8. Circuit arrangement according to Claim 7, **characterized in that** the two switching elements (TS1a, TS1b) for a column of memory cells of a memory segment (60) are arranged adjacent to one another or not adjacent to one another in particular at different ends of the column.

9. Circuit arrangement (50) according to one of the preceding claims, **characterized in that** each memory cell contains only one transistor (T11),
and/or **in that** the transistor (T11) is a floating gate transistor,
and/or **in that** a drive circuit is constructed in such a way that the transistor (T11) is programmed and/or erased with a uniform channel, in particular using a tunneling current,
and/or **in that** the switching elements (TS1a, TS1b) are field effect transistors or analog switches which preferably contain a pMOS transistor connected in parallel with an nMOS transistor,
and/or **in that** the control elements (TS1a, TS2a) for connecting the bit lines (BL1, W1) are electrically conductively connected to a common control line (SLa) in particular the control elements (TS1a, TS2a) of a memory segment (60),
and/or **in that** the control elements (TS1b, TS2b) for connecting the collective line (M) to the bit lines (W1, W2) are electrically conductively connected to a common control line (SLb) in particular the control elements (TS1b, TS2b) of a memory segment (60),
and/or **in that** the circuit arrangement contains, in addition to the switching elements, multiplex circuits for the selection of word lines and bit lines,
and/or **in that** the switching elements do not have a data storage function.

10. Circuit arrangement (50) according to one of the preceding claims, **characterized in that** local bit lines (BL1, W1) of a column are arranged such that they overlap one another in the direction of the normal to a substrate main area.

## Revendications

1. Ensemble (50) de circuit de mémoire intégré,
comprenant une pluralité de cellules de mémoire, disposée en forme de matrice, qui comportent chacune au moins un transistor (T11, T21),
comprenant des conducteurs (WL1, WL2) de mot sur les électrodes (20) de commande des transistors (T11, T22) de cellules de mémoire d'une ligne de la matrice,
comprenant des conducteurs (BL, BL2, B1, B2) de bit sur des électrodes (24, 28) formant borne des transistors (T11, T21) de cellules de mémoire d'une colonne de la matrice,
comprenant au moins un élément (TS1a, TS2a) de commutation par colonne, qui permet de produire et de séparer une liaison conductrice de l'électricité entre deux conducteurs (BL1, W1) de bit de la même colonne,
et comprenant un même conducteur (M) collecteur dans la direction des lignes de la matrice, dans lequel au moins un autre élément (TS1b) de commutation par colonne permet la production et la séparation d'une liaison conductrice de l'électricité du conducteur (M) collecteur à respectivement un conducteur (W1, W2) de bit,
dans lequel les conducteurs (BL1, BL2) de bit sont des conducteurs de bit locaux et dans lequel un circuit de commande est tel que le transistor (T11) est programmé avec un canal uniforme de sorte que l'oxyde de tunnel est sollicité d'une manière uniforme,
**caractérisé en ce qu'**il y des sillons (G1, G2) isolants entre lesquels se trouve des caissons dopés, isolés les uns des autres et reliant respectivement les zones de substrat des transistors d'une colonne, et
**en ce qu'**il y une unité de commande qui commande les éléments (TS1a) de commutation pour relier deux conducteurs (BL1, W1) de bit pendant la programmation en alternance aux éléments (TS1b) de commutation pour relier le conducteur (M) collecteur au conducteur (W1, W2) de bit, dans lequel toujours seulement l'un des éléments (TS1a, TS1b) de commutation conduit et l'autre élément de commutation bloque.

2. Ensemble (50) de circuit suivant la revendication 1, **caractérisé en ce qu'**un conducteur (W1) de bit, relié d'une manière conductrice de l'électricité à un élément (TS1) de commutation, est disposé dans une zone dopée, de préférence, dans une zone dopée d'un substrat semi-conducteur,
et **en ce que** l'autre conducteur (BL1) de bit, relié d'une manière conductrice de l'électricité à l'élément (TS1) de commutation, est un conducteur métallique qui est en un métal ou qui contient une couche de métal.

3. Ensemble (50) de circuit suivant la revendication 1 ou 2, **caractérisé en ce que** les conducteurs (BL1, BL2) de bit sont des conducteurs de bit locaux, qui peuvent être reliés d'une manière conductrice de l'électricité à des conducteurs (GBL1, GBL2) globaux par d'autres éléments de commutation, les conducteurs (BL1, BL2) de bits locaux fixant un segment (60) de mémoire, et dans lequel l'ensemble (50) de circuit comporte au moins deux segments (60, 62) de mémoire.

4. Ensemble (50) de circuit suivant la revendication 3, **caractérisé en ce que** le nombre de conducteurs (GBL1, GBL2) de bit globaux est égal à la moitié du nombre de conducteurs (BL1, BL2) de bit locaux métalliques.

5. Ensemble (50) de circuit suivant la revendication 3 ou 4, **caractérisé en ce** l'élément (TS1a) du commutation est disposé à une extrémité des cellules (T11, T12) de mémoire d'une colonne d'un segment (60) de mémoire et en ce que l'élément (TS1a) de commutation est disposé entre les cellules de mémoire d'une colonne d'un segment (60) de mémoire, de préférence au milieu d'une colonne.

6. Ensemble (50) de circuit suivant la revendication 5, deuxième possibilité, **caractérisé en ce que** l'élément (TS1a) de commutation est disposé entre les cellules de mémoire d'une colonne d'un segment (60) de mémoire au milieu d'une colonne.

7. Ensemble (50) de circuit suivant l'une des revendications précédentes, **caractérisé en ce que** le conducteur (M) collecteur applique le même potentiel à la lecture et à la programmation.

8. Ensemble (50) de circuit suivant la revendication 7, **caractérisé en ce** les deux éléments (TS1a, TS1b) de commutation pour une colonne de cellules de mémoire d'un segment (60) de mémoire sont voisins l'un de l'autre ou ne sont pas voisins l'un de l'autre, en étant notamment à des extrémités différentes de la colonne.

9. Ensemble (50) de circuit suivant l'une des revendications précédentes, **caractérisé en ce que** chaque cellule de mémoire ne comporte qu'un transistor (T11) et/ou **en ce que** le transistor (T11) est un transistor floating-gate,
et/ou **en ce que** le circuit de commande est tel que le transistor (T11) est programmé et/ou effacé avec un canal uniforme, en utilisant notamment un courant de tunnel et/ou **en ce que** les éléments (TS1a, TS1b) de commutation sont des transistors à effet de champ ou des commutateurs analogiques qui comportent, de préférence, un transistor pMOS monté en parallèle avec un transistor nMOS,
et/ou **en ce que** les éléments (TS1a, TS1b) de commande sont, pour relier les conducteurs (BL1, W1) de bit, reliés d'une manière conductrice de l'électricité à une ligne (SLa) de commande commune, notamment les éléments (TS1a, TS2a) de commande d'un segment (60) de mémoire,
et/ou **en ce que** les éléments (TS1b, TS2b) de commande sont, pour relier les conducteurs (M) collecteurs aux lignes (W1, W2) de bit, reliés d'une manière conductrice de l'électricité à une ligne (SLb) de commande commune, notamment les éléments (TS1b, TS2b) de commande d'un segment (60) de mémoire,
et/ou **en ce que** l'ensemble de circuit comporte, en plus des éléments de commutation, des circuits de multiplexage pour sélectionner des conducteurs de mots et des conducteurs de bit,
et/ou **en ce que** les éléments de commutation n'ont pas de fonction de mémorisation de données.

10. Ensemble (50) de circuit suivant l'une des revendications précédentes, **caractérisé en ce que** des conducteurs (BL1, W1) de bit locaux d'une colonne sont disposés en chevauchement les uns avec les autres dans la direction normale à une surface principale de substrat.
